# EUROPEAN PATENT APPLICATION

(11) **EP 4 701 079 A1**
(43) Date of publication of application: **25.02.2026**
(21) Application number: 24195189.6
(22) Date of filing: 19.08.2024
(51) Int. Cl.: H03K 17/12, H02M 1/00, H02M 1/08, H03K 17/28, H03K 17/567

(54) **GATE DRIVER ARCHITECTURE FOR HYBRID SIC MOSFET AND SI IGBT POWER SEMICONDUCTOR DEVICE**

(71) Applicant: Volvo Car Corporation, 405 31 Göteborg (SE)
(72) Inventor: ZHANG, Chi, SE-405 31 Göteborg (SE); NEGRI, Riccardo, SE-405 31 Göteborg (SE)
(74) Representative: Nederlandsch Octrooibureau

(57) **Abstract**

A gate driver integrated chip including a high voltage side and a low voltage side, wherein the high voltage side is insulated from the low voltage side; two or more output stages on the high voltage side configured to transmit a first voltage to a silicon carbide metal-oxide-semiconductor field-effect transistor, SiC MOSFET, and transmit a second voltage to a silicon insulated-gate bipolar transistor, Si IGBT; a first controller on the low voltage side; a second controller on the high voltage side in communication with the two or more output stages; and an analogue-to-digital, ADC, circuit on the high voltage side; wherein the first controller is in communication with both the ADC circuit and the second controller, and wherein the ADC circuit is in further communication with the second controller, wherein the ADC circuit is configured to receive an inverter output current, a SiC MOSFET temperature, and a Si IGBT temperature, wherein the first controller is configured to: receive the inverter output current, the SiC MOSFET temperature, and the Si IGBT temperature via the ADC circuit; determine a temperature difference based on the inverter output current, wherein the temperature difference is a difference between the SiC MOSFET temperature and the Si IGBT temperature; adjust a SiC MOSFET current and a Si IGBT current based on the temperature difference or determine a first time difference and a second time difference, wherein the first time difference is a time difference between a time when the first output stage switches on and a time when the second output stage switches on and the second time difference is a time difference between a time when the first output stage switches off and a time when the second output stage switches off, wherein the second controller is configured to: receive the first time difference and the second time difference from the first controller, control at least one gate of the two or more output stages based on the first time difference and the second time difference.

## Description

### Technical Field

The present disclosure relates to the field of integrated circuits, in particular a gate driver architecture for producing a drive input for both a silicon carbide metal-oxide-semiconductor field-effect transistor (SiC MOSFET) and a silicon insulated-gate bipolar transistor (Si IGBT) of a hybrid semiconductor device.

### Background of the Present Disclosure

Hybrid semiconductors including different transistors, such as SiC MOSFET and Si IGBT, may result in an intolerable junction temperature difference between the different transistors.

SiC MOSFET has increased in popularity due to its fast switching speed and has a relatively higher tolerance and higher junction temperature as compared to Si IGBT, and relatively higher thermal conductivity as compared to Si IGBT. The automotive industry, in particular, has discovered several applications for SiC MOSFET. However, SiC MOSFETs are considerably more costly than Si based power devices such as Si IGBT.

Devices including both SiC MOSFET and Si IGBT devices have been developed to take advantage of the performance of SiC MOSFET devices and offset their costs with comparatively less costly Si IGBT devices.

Using strictly SiC MOSFET devices may unnecessarily incur greater costs. Using strictly Si IGBT devices may lead to undesired performance issues.

Instead of using strictly Si IGBT devices or strictly SiC MOSFET devices, Si IGBT devices may work in parallel with SiC MOSFET devices. A hybrid or combined device incorporating Si IGBT devices and SiC MOSFET devices in parallel results in a desired onstate resistance.

However, a hybrid semiconductor device may result in an unbalanced junction temperature because the SiC MOSFET devices and Si IGBT devices are different semiconductor devices. Therefore, it would be desirable in the field of integrated circuits to provide gate sequence control for hybrid SiC MOSFET and Si IGBT devices to maintain an allowable temperature difference between the SiC MOSFET and the Si IGBT to achieve an allowable switch loss.

The gate sequence control may maintain a temperature difference within a desired temperature range, thus maintaining the power module's capability to deliver a current.

The background section relating to integrated circuits, in particular in automotive inverter applications, is merely intended to provide a contextual overview of some current issues and is not intended to be exhaustive. Other contextual information may become apparent to a person of skill in the art upon review of the following detailed description.

### Summary of the Disclosure

According to an embodiment, a gate driver integrated chip may include a high voltage side and a low voltage side, wherein the high voltage side is insulated from the low voltage side. The gate driver may further include two or more output stages on the high voltage side configured to transmit a first voltage to a SiC MOSFET and transmit a second voltage to a Si IGBT. The gate drive may further include a first controller on the low voltage side. The gate driver may further include a second controller on the high voltage side in communication with the two or more output stages; and further include an analogue-to-digital (ADC) circuit on the high voltage side, wherein the first controller is in communication with both the ADC circuit and the second controller, and wherein the ADC circuit is in further communication with the second controller, wherein the ADC circuit is configured to receive an inverter output current, a SiC MOSFET temperature, and a Si IGBT temperature from a hybrid semiconductor device, wherein the first controller is configured to: receive the inverter output current, the SiC MOSFET temperature, and the Si IGBT temperature via the ADC circuit. The first controller may determine a temperature difference based on the inverter output current, wherein the temperature difference is a difference between the SiC MOSFET temperature and the Si IGBT temperature and the first controller determines whether to adjust a SiC MOSFET current, a Si IGBT current or a delta current, based on the temperature difference. If it is determined to adjust any of the SiC MOSFET current, the Si IGBT current, or the delta current, the first controller controls the adjustment. If it is determined not to adjust the any of the SiC MOSFET current, the Si IGBT current, or the delta current the first controller determines a working mode based on the temperature difference and transmits the estimated temperature difference and the working mode information to the second controller. The second controller may determine a first time difference and a second time difference based on the temperature difference, wherein the first time difference is a time difference between a time when the first output stage switches on and a time when the second output stage switches on and the second time difference is a time difference between a time when the first output stage switches off and a time when the second output stage switches off. The second controller is configured to determine the first time difference and the second time difference based on the working mode information and temperature difference received from the first controller and control at least one gate of the two or more output stages based on the first time difference and the second time difference.

Hybrid semiconductor devices require two different voltages. Providing a single gate drive with the capability of delivering two different voltages, one for each component of a hybrid semiconductor device, eliminates the need for two different voltage sources for a hybrid semiconductor power module. Controlling the different currents of the SiC MOSFET and the Si IGBT and switching the output stage gates to maintain an appropriate junction temperature of the hybrid semiconductor device by maintaining an appropriate temperature difference between the SiC MOSFET and the Si IGBT. Therefore, the gate driver can provide two different voltages to the hybrid semiconductor device without a risk of performance or damage. References to junction temperature of the hybrid semiconductor device imply the temperature difference between the SiC MOSFET and the Si IGBT of they hybrid semiconductor device.

According to an embodiment the ADC circuit includes four channels. The four ADC channels, which may be connected to the hybrid semiconductor device, receive information about the hybrid semiconductor device such as the inverter output current. This information may be communicated to the first controller and/or the second controller. The first controller and the second controller of the gate driver may modify operations of the gate driver based on the register information received at the four ADC channels.

According to an embodiment the gate driver may further include a first communication line between the ADC circuit and the first controller, a second communication line between the ADC circuit and the second controller, and a serial peripheral interface, SPI, in communication with the second controller to configure the four channels of the ADC circuit. The register information received at the four ADC channels may be transmitted directly from the ADC to the first controller or transmitted from the ADC to the first controller via the second controller. The communication lines allow the first controller and the second controller to verify the register information.

According to an embodiment the first controller is configured to store a value of the maximum allowable temperature difference or maximum temperature difference value. The maximum temperature difference value may be predetermined and stored on the gate driver or a configurable parameter of the gate driver which may be updated through a SPI of the gate driver. The first controller may determine an operation of the gate driver based on a comparison between the maximum temperature difference and a determined temperature difference between the SiC MOSFET and the Si IGBT of the hybrid semiconductor device.

According to an embodiment the first controller increases or decreases the first current when the temperature difference is less than or equal to the maximum difference. Adjusting the first current without adjusting the gates of the output stages maintains the junction temperature of the hybrid semiconductor device without the costly operation of switching the gates of the output stages.

According to an embodiment the first controller increases or decreases the second current when the temperature difference is less than or equal to the maximum difference. Adjusting the second current without adjust the gates of the output stages maintains the junction temperature of the hybrid semiconductor device without the costly operation of switching the gates of the output stages.

According to an embodiment the second controller controls the at least one gate to generate a first time difference and a second time difference between a first output stage and a second output stage, wherein the first time difference is a time difference between when the first output stage switches on and the second output stage switches on and the second time difference is a time difference between when the first output stage switches off and the second output stage switches off. Adjusting the gates of the output stages controls when voltages are transmitted to the SiC MOSFET and the Si IGBT of the hybrid semiconductor device. When a junction temperature of the hybrid semiconductor device has reached a certain threshold, the gate driver controls when and to which element of the hybrid semiconductor device, the SiC MOSFET or the Si IGBT, a voltage is delivered. The gates are controlled to maintain an appropriate temperature difference between the SiC MOSFET and the Si IGBT of the hybrid semiconductor device such that normal operation is maintained. For example, the gate driver my control an output stage gate to transmit a voltage to a Si IGBT first and delay a further output stage voltage from transmitting a voltage to a SiC MOSFET. Because the SiC MOSFET tolerates higher operating temperatures than the Si IGBT, it may be desirable to have the SiC MOSFET in an onstate for less time than the Si IGBT

According to an embodiment the first time difference is set to switch on the first output stage and the second output stage at the same time. Turning on both output stages at the same time allows transmitting a voltage to both the SiC MOSFET and the Si IGBT of the hybrid semiconductor device at the same time. This may be because the junction temperature of the hybrid semiconductor device is relatively low when compared to the maximum allowable junction temperature.

According to an embodiment the first time difference is set to switch on the first output stage before the second output stage. Turning on the first output stage before turning on the second output stage delays transmitting a voltage to a second device of the hybrid semiconductor device. For example, transmitting a voltage to the SiC MOSFET and delaying transmitting a voltage to the Si IGBT of the hybrid semiconductor device so that they are not both on for the same amount of time. Delaying transmission of a voltage may maintain the junction temperature of the hybrid semiconductor device at an allowable temperature in response to determining that the junction temperature has reached the maximum allowable junction temperature.

According to an embodiment the first time difference is set to switch on the first output stage after the second output stage. Turning on the first output stage after turning on the second output stage delays transmitting a voltage to a first device of the hybrid semiconductor device. For example, delaying transmitting a voltage to the SiC MOSFET and transmitting a voltage to the Si IGBT of the hybrid semiconductor device so that they are not both on for the same amount of time. Delaying transmission of a voltage may maintain the temperature difference between the SiC MOSFET and the Si IGBT of the hybrid semiconductor device at an allowable value in response to determining that the junction temperature of the hybrid semiconductor device has reached the maximum allowable junction temperature.

According to an embodiment the second time difference is set to switch off the first output stage and the second output stage at the same time. Turning off both output stages at the same time terminates transmitting a voltage to both the SiC MOSFET and the Si IGBT of the hybrid semiconductor device at the same time. This may be because the junction temperature of the hybrid semiconductor device is relatively high when compared to the maximum allowable junction temperature.

According to an embodiment the second time difference is set to switch off the first output stage before the second output stage. Turning off the first output stage before turning off the second output stage delays terminating transmitting a voltage to a second device of the hybrid semiconductor device. For example, delaying terminating transmitting a voltage to the Si IGBT and terminating transmitting a voltage to the SiC MOSFET of the hybrid semiconductor device so that they are not both on for the same amount of time. Delaying terminating transmission of a voltage may maintain the junction temperature of the hybrid semiconductor device at an allowable temperature in response to determining that the junction temperature of hybrid semiconductor device has reached or is approaching the maximum allowable junction temperature.

According to an embodiment the second time difference is set to switch off the first output stage after the second output stage. Turning off the first output stage after turning off the second output stage delays terminating transmitting a voltage to a first device of the hybrid semiconductor device. For example, delaying terminating transmitting a voltage to the SiC MOSFET and terminating transmitting a voltage to the Si IGBT of the hybrid semiconductor device so that they are not both on for the same amount of time. Delaying terminating transmission of a voltage may maintain the junction temperature of the hybrid semiconductor device at an allowable temperature in response to determining that the junction temperature of the hybrid semiconductor device has reached the maximum allowable junction temperature.

According to an embodiment adjusting the first time difference and/or the second time difference in response to the temperature difference of the hybrid semiconductor device being greater than or equal to the maximum temperature difference. Adjusting the gates of the output stages in response to determining that the junction temperature of the hybrid semiconductor device has reached a maximum allowable temperature maintains the junction temperature at an allowable operating temperature.

According to an embodiment the second controller is configured to store an algorithm, wherein the algorithm is set to configure the first current and the second current or the first time difference and the second time difference based on a determined working mode. Storing the configuration on the second controller may eliminate transmission of control signals because the second controller is directly connected to the output stages. Configuration of the gates may be dependent on the use of the hybrid semiconductor device. For example, if it is crucial that the SiC MOSFET device remain on, the gates may be configured to prioritize transmitting a voltage to the SiC MOSFET device over transmitting a voltage to the Si IGBT device. Alternatively, the algorithm may be stored on the first controller and configurable by a user through the SPI. The algorithm may be transmitted to the second controller from the first controller or the first controller may execute the algorithm and communicate the results to the second controller.

### Brief Description of the Drawings

The disclosure will now be described in further detail with reference to the drawings that shows one embodiment of the present disclosure:
FIG. 1 illustrates a device of a hybrid semiconductor device including at least one Si IGBT and at least one SiC MOSFET in parallel;
FIG. 2 illustrates a comparison chart of on-state voltage for different currents for each of a Si IGBT device, a SiC MOSFET device, and a hybrid (Si IGBT and SiC MOSFET in parallel) device;
FIG. 3 illustrates a chart of current amplitude of an inverter output current;
FIG. 4 illustrates five possibilities of gate sequences for concurrently or simultaneously providing voltage to a Si IGBT device and a SiC MOSFET device;
FIG. 5 illustrates a gate driver integrated circuit configured to transmit voltages to a Si IGBT device and a SiC MOSFET device;
FIG. 6 illustrates an output stage of a gate driver integrated circuit configured to transmit voltages to a Si IGBT device or a SiC MOSFET device;
FIG. 7 illustrates three options for gate sequence control of two output stages of a gate driver integrated circuit;
FIG. 8 illustrates a flowchart of embedded code for a first controller (digital core P) and a second controller (digital core S) of a gate driver integrated circuit according to some embodiments;
FIG. 9 illustrates a exemplary flow of operating rules for a hybrid (Si IGBT and SiC MOSFET in parallel) device according to some embodiments;
FIG. 10 illustrates a gate driver integrated circuit configured to deliver voltages to a power module which includes a Si IGBT device and a SiC MOSFET device connected in parallel of a hybrid device;
FIG. 11 illustrates a gate driver integrated circuit configured to deliver voltages to discrete Si IGBT devices and discrete SiC MOSFET devices.

### Detailed Description

The present disclosure is directed to a gate driver integrated circuit, in particular a gate driver architecture for producing a drive input for both a SiC MOSFET and a Si IGBT.

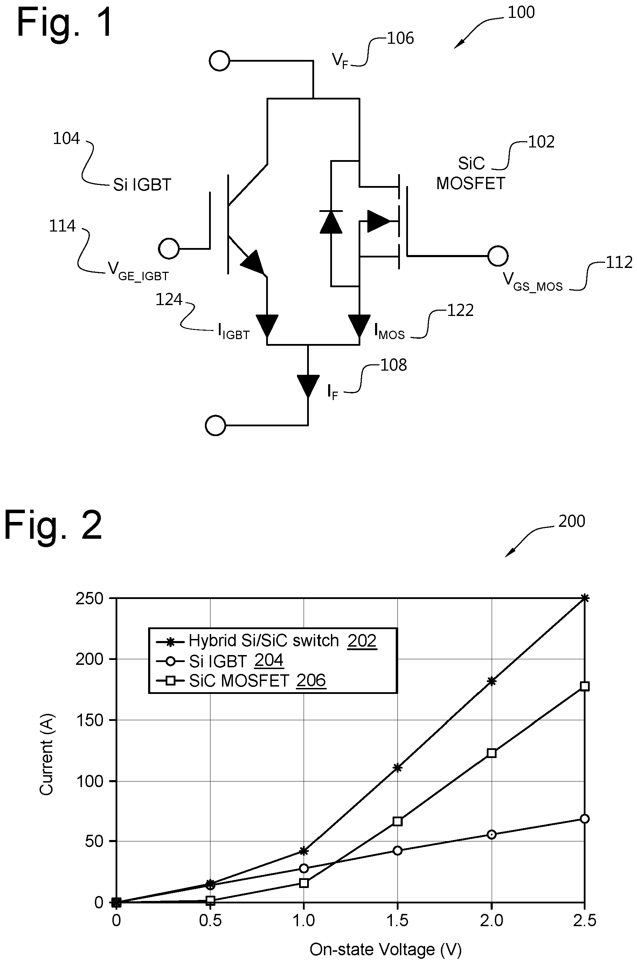

FIG. 1 is a hybrid semiconductor device 100 including at least one SiC MOSFET 102 and at least one Si IGBT 104 in parallel. The SiC MOSFET 102 may receive MOSFET voltage 112 such as a gate source voltage. Upon receipt of MOSFET voltage 112, such that MOSFET voltage 112 is greater than or equal to a MOSFET threshold of the SiC MOSFET 102, MOSFET current 122 flows through SiC MOSFET 102. The Si IGBT 104 may receive IGBT voltage 114, such that IGBT voltage 114 is greater than or equal to a IGBT threshold of the Si IGBT 104, IGBT current 124 flows through Si IGBT 104. As a result, hybrid semiconductor device 100 may generate forward voltage 106 and forward current 108.

Hybrid semiconductor device 100 may include a plurality of SiC MOSFETs 102 and a plurality of Si IGBTs 104. Hybrid semiconductor device 100 may include an equal number of SiC MOSFETs 102 and Si IGBTs 104. Hybrid semiconductor device 100 may include more SiC MOSFETs 102 than Si IGBTs 104. Hybrid semiconductor device 100 may include less SiC MOSFETs 102 than Si IGBTs 104.

FIG. 2 illustrates a comparison chart 200 of measured on-state voltage for multiple power module devices at different currents . Line 202 illustrates the measured on-state voltage of a hybrid device such as hybrid semiconductor device 100. Line 204 illustrates the measured on-state voltage of a strictly IGBT device. Line 206 illustrates the measured on-state voltage of a strictly MOSFET.

As shown in chart 200, line 202 of hybrid Si/SiC devices have lower resistance as compared to the line 204 of a strictly Si IGBT device and/or line 206 of a strictly SiC MOSFET device at the same voltage. As load increases, the benefit of the hybrid device becomes evident. Therefore, the hybrid Si/SiC devices provide lower conduction power loss when compared to both Si IGBT and SiC MOSFET devices. The switching speed of the SiC MOSFET in combination with gate sequence control between Si IGBT and SiC MOSFET devices of a hybrid device can achieve much lower switching power loss compared to Si IGBT devices. As a result, hybrid devices offer high efficiency and high-power density energy conversion systems.

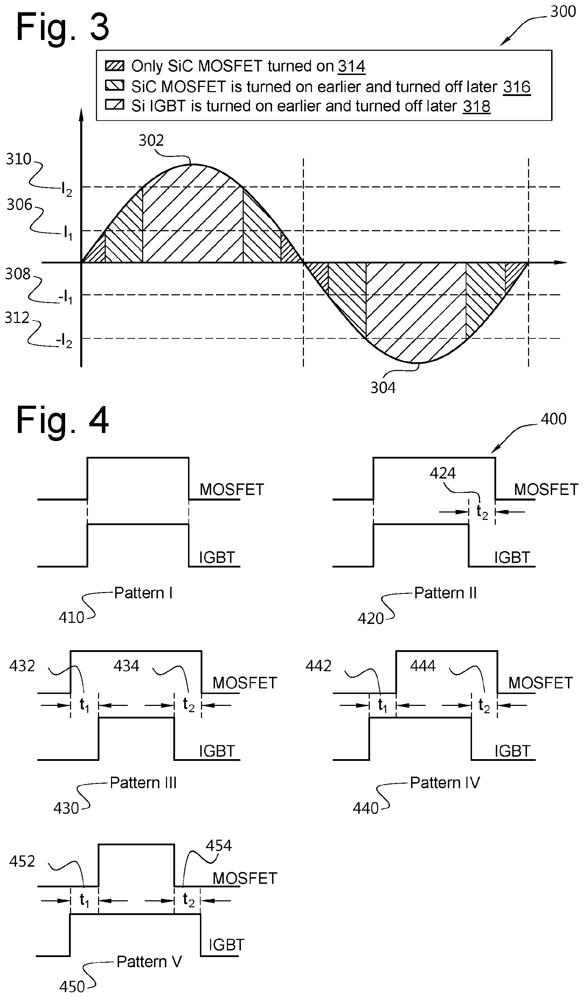

Fig. 3 illustrates an exemplary current cycle 300 of an inverter output current of a hybrid semiconductor device, such as hybrid semiconductor device 100. Current cycle 300 may be an alternating current with a positive maximum 302 and a negative maximum 304. Controlling the switch gate control may be based on the magnitude of the current. A first current may be represented as having a first positive magnitude 306 and a first negative magnitude 308. First positive magnitude 306 and first negative magnitude 308 may represent a load current the hybrid semiconductor device. A second current may be represented as having a second positive magnitude 310 and a second negative magnitude 312. Second positive magnitude 310 and second negative magnitude 312 may represent a safe operating current of the SiC MPSFET device of the hybrid semiconductor device. A gate controller may determine how to control gates based the inverter output current.

As shown by areas 314, the current may be lower than or equal to the magnitude first positive current 306 and first negative current 308. The gate controller may control the hybrid semiconductor device such that during the time represented by areas 314, only the SiC MOSFET device is turned on. During the time represented by areas 314, the Si IGBT device may be in an off state.

As shown by areas 316, the current may be greater than or equal to the magnitude of the first positive current 306 and first negative current 308. Additionally, the current may be lower than or equal to the magnitude of the second positive current 310 and a second negative current 312. The gate controller may control the hybrid semiconductor device such that during the time represented by areas 316, the SiC MOSFET device is turned on before turning on the Si IGBT device. During the time represented by areas 316, the SiC MOSFET device is turned off after turning off the Si IGBT device.

As shown by areas 318, the current may be greater than or equal to the magnitude of the second positive current 310 and second negative current 312. The gate controller may control the hybrid semiconductor device such that during the time represented by areas 318, the Si IGBT device is turned on before turning on the SiC MOSFET device. During the time represented by areas 318, the Si IGBT device is turned off after turning off the SiC MOSFET device.

As illustrated by FIG. 3, the gate driver may control the gate sequence between the SiC MOSFET device and the Si IGBT device based on the inverter output current of the hybrid device. The gate sequence defined by a time difference between turning on/off the SiC MOSFET device and the Si IGBT device is explained in further detail with regard to FIG. 4.

FIG. 4 illustrates a sample of available patterns of switching between the SiC MOSFET device and the Si IGBT device of a hybrid semiconductor device. Each pattern may be defined by a time different between turning on/off the SiC MOSFET device and the Si IGBT device. First pattern 410 may represent a scenario where the SiC MOSFET device and the Si IGBT device are turned on and off at the same time. Said differently, there is no time difference between turning on/off the SiC MOSFET device and the Si IGBT device.

Second pattern 420 may represent a scenario where the SiC MOSFET device and the Si IGBT device are turned on at the same time. However, the SiC MOSFET device is turned off after turning off the Si IGBT device. Off time difference 424 represents the amount of time between turning off the Si IGBT device and turning off the SiC MOSFET device. Off time difference 424 may be represented as a positive or negative value depending on the perspective. For example, if off time difference 424 is taken from the perspective of the SiC MOSFET device, off time difference 424 may have a negative value because the time off of the Si IGBT device would be in the past as compared to the time off of the SiC MOSFET device.

Third pattern 430 may represent a scenario where the SiC MOSFET device is turned on before turning on the Si IGBT device. Additionally, the SiC MOSFET device is turned off after turning off the Si IGBT device. On time difference 432 represents the amount of time between turning on the SiC MOSFET device and turning on the Si IGBT device. Off time difference 434 represents the amount of time between turning off the Si IGBT device and turning off the SiC MOSFET device. On time difference 432 and off time difference 434 may be represented as a positive or negative value depending on the perspective as previously explained.

Fourth pattern 440 may represent a scenario where the SiC MOSFET device is turned on after turning on the Si IGBT device. Additionally, the SiC MOSFET device is turned off after turning off the Si IGBT device. On time difference 442 represents the amount of time between turning on the Si IGBT device and turning on the SiC MOSFET device. Off time difference 444 represents the amount of time between turning off the Si IGBT device and turning off the SiC MOSFET device. On time difference 442 and off time difference 444 may be represented as a positive or negative value depending on the perspective as previously explained.

Fifth pattern 450 may represent a scenario where the SiC MOSFET device is turned on after turning on the Si IGBT device. Additionally, the SiC MOSFET device is turned off before turning off the Si IGBT device. On time difference 452 represents the amount of time between turning on the Si IGBT device and turning on the SiC MOSFET device. Off time difference 454 represents the amount of time between turning off the SiC MOSFET device and turning off the Si IGBT device. On time difference 452 and off time difference 454 may be represented as a positive or negative value depending on the perspective as previously explained.

The on time differences 432, 442, and 452 off time differences 424, 434, 444, and 454 may be determined to maintain a junction temperature of a hybrid semiconductor device within an allowable range. It should be noted that other patterns may be available.

A single gate driver integrated chip according to this disclosure may implement a gate sequence to deliver a first voltage to the SiC MOSFET device and transmit a second voltage to the Si IGBT device of a hybrid power semiconductor device.

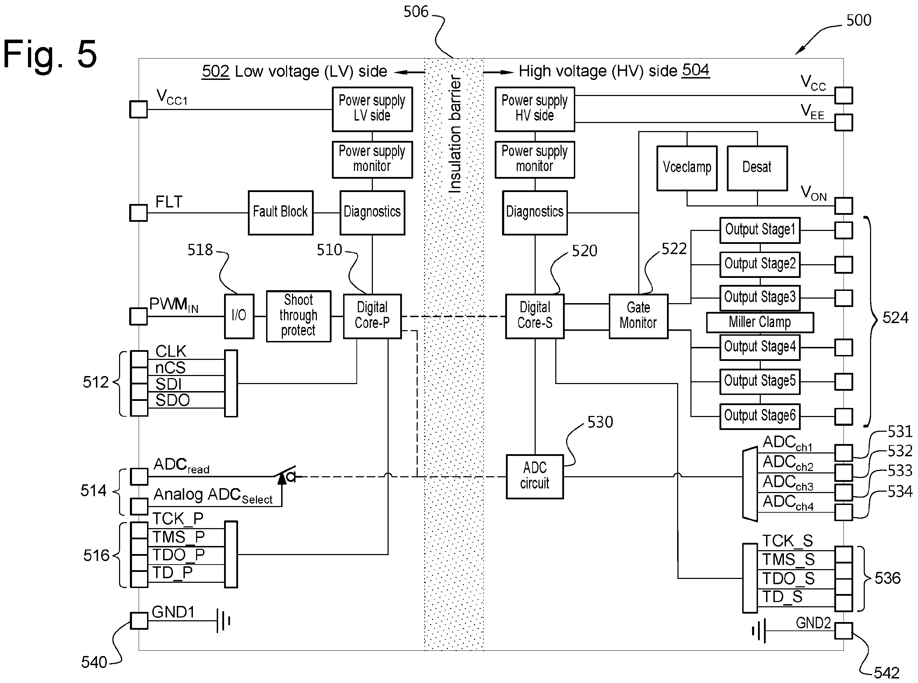

FIG. 5 illustrates a gate driver integrated chip (IC) 500 configured to deliver voltages to both SiC MOSFET device(s) and Si IGBT device(s) of a hybrid semiconductor device. Gate driver IC 500 includes low voltage side 502 and high voltage side 504. Low voltage side 502 may be separated from high voltage side by insulation barrier 506. Insulation barrier 506 may create an insulating link between high voltage side 504 and low voltage side 502. As a result, insulation layer 506 may isolate low voltage side 502 from the high voltage connected to high voltage side 504.

low voltage side 502 may include a serial peripheral interface (SPI) 512. SPI 512 may be configured to receive a low voltage signal. As an example, SPI 512 may include 4 pins: a clock (CLK) pin, a chip select (CS) pin, a serial data in (SDI) pin, and a serial data out (SDO) pin. SPI 512 may be in communication with first digital controller 510.

First digital controller 510 may receive a modulated signal via a digital input output (I/O) board 518 also on low voltage side 502. I/O board 518 may be in communication with first digital controller 510 with shoot through protection. The shoot through protection may include a power switch to prevent first digital controller 510 and I/O board 518 from being on at the same time.

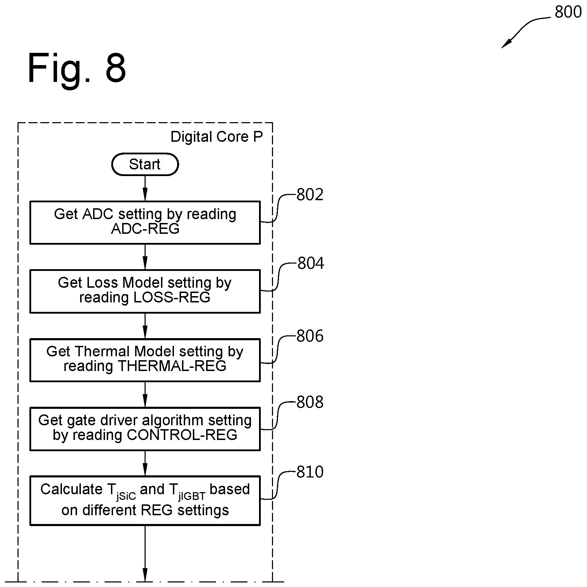

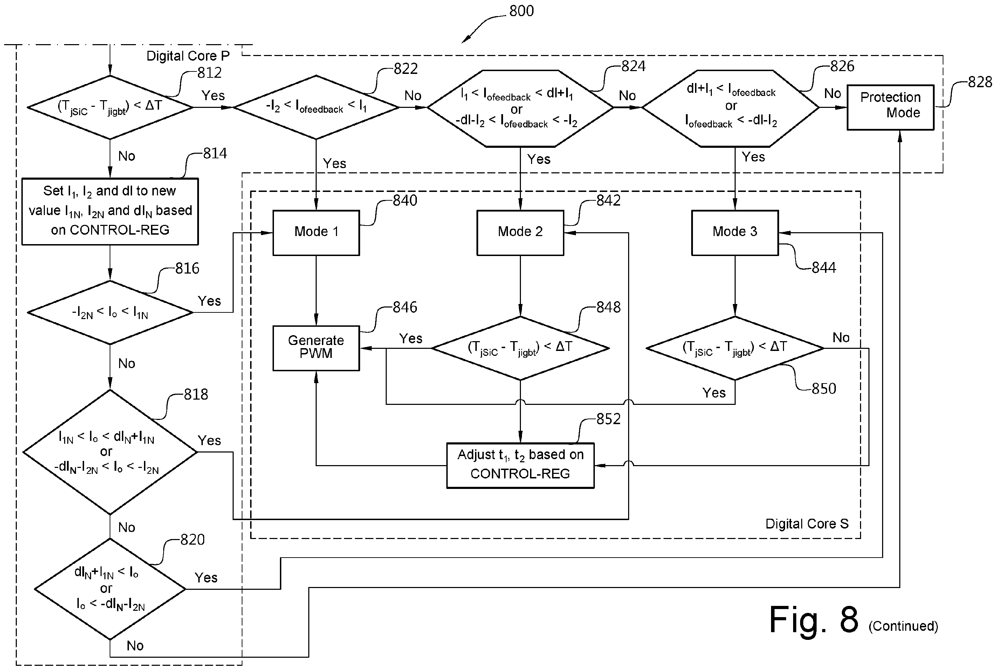

First digital controller 510 may receive customized code for controlling the gates. First digital controller 510 may receive the customized code via SPI 512 by setting the specific registers of SPI 512. An exemplary method of controlling the gates is further discussed with respect to FIG. 8.

Low voltage side 502 may further include ground reference signal source 540 switch 514 to switch ADC 530 between a read mode and a selection mode. Low voltage side interface 516 interfaces to download code to first controller 510. This may be useful during implementation, if customized control code is desired over the control code already stored on first digital controller (digital core p) 510.

Low voltage side 502 may further include first Joint Test Action Group (JTAG) 516 which includes four pins: a test clock (TCK) pin, a test mode select (TMS) pin, a test data out (TDO) pin, and a test data in (TDI) pin. The JTAG may test gate driver 500 via: TCK to synchronize operations of the gate driver; TMS to determinate a state of the gate driver; TDI during a rising edge of the TCK; and TDO during a falling edge of the TCK. With the information received and or transmitted via first JTAG 516, gate driver IC 500.

High voltage side 504 may include second digital controller 520. Second controller 520 may be in communication with gate monitor 522 to control gates of output stages 524. Second controller 520 may be in further communication with ADC 530 to read information from ADC channels 531-534.

Gate monitor 522 may control gates of output stages 524 to control transmission of voltages to Si IGBT devices and SiC MOSFET devices of a hybrid device based on information received from second digital controller 520. ADC 530 may read information from and/or select channels 531-534 and transmit the information to second controller 520.

High voltage side interface 536 interfaces to download code to second controller 520. This may be useful during implementation, if customized control code is desired over the control code already stored on second digital controller (digital core s) 520. High voltage side 504 may further include ground reference signal source 542.

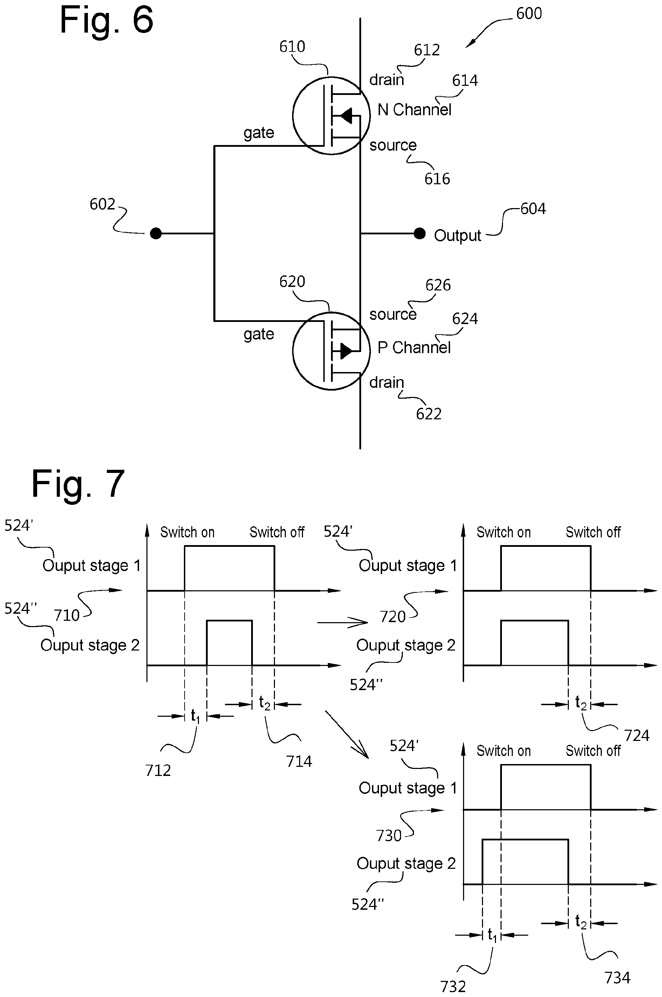

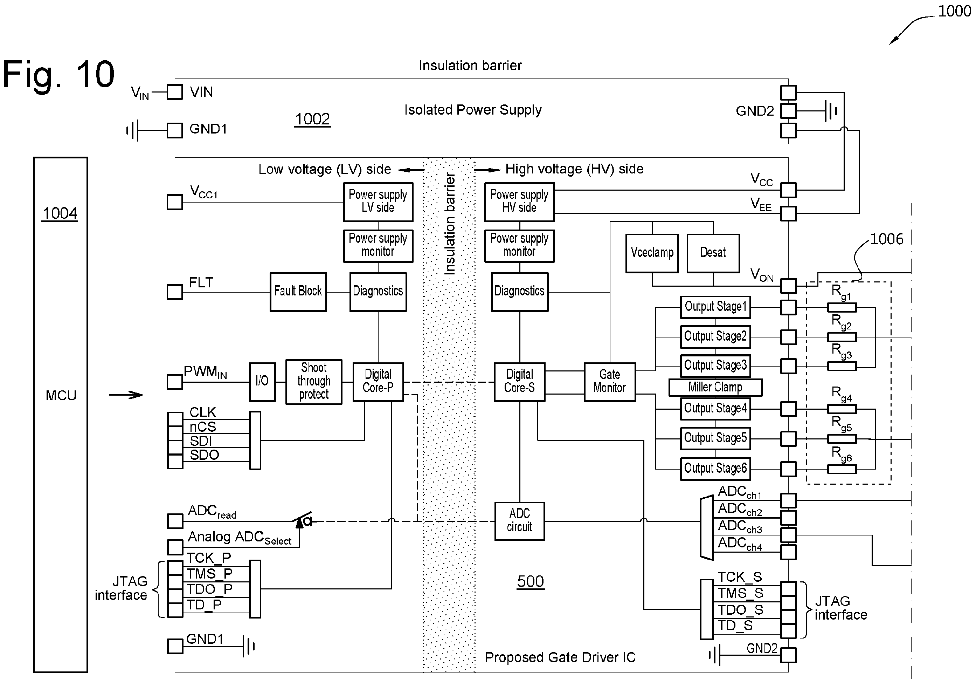

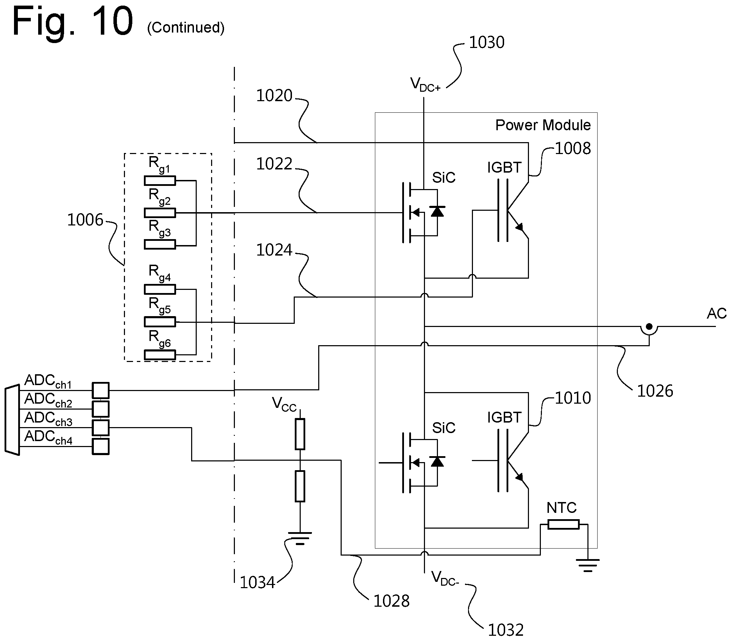

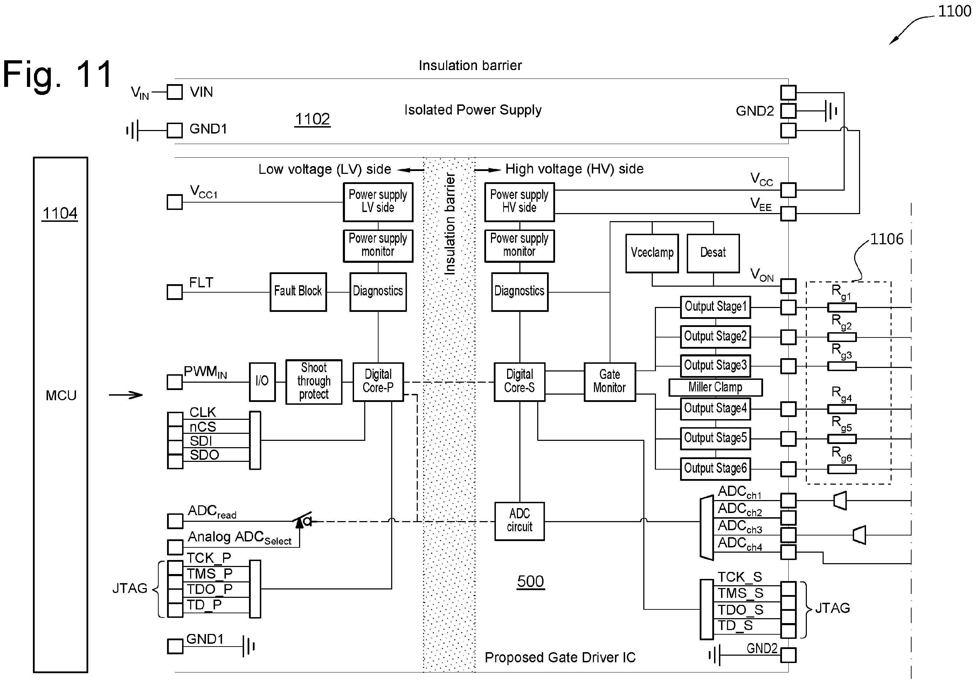

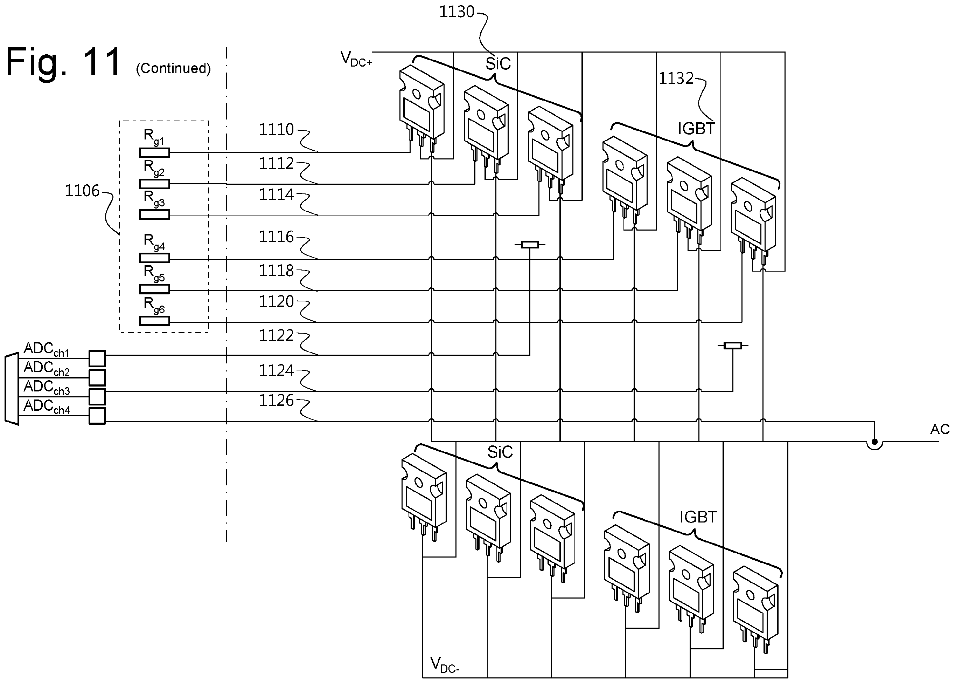

FIG. 6 illustrates a push pull circuit 600 of an output stage such as output stages 524. Each of the output stages 524 may support a hybrid semiconductor device (as described in FIG. 10) and discrete parallel devices (as described in FIG. 11).

Push pull circuit 600 may include input 602. Input 602 may be directly connected to second controller 520 and configured to receive a control signal to switch the gates 610 and 620 on or off. Push pull circuit 600 may include N-channel gate 610 and P-channel gate 620. N-channel gate 610 may include drain 612, N-channel 614, and source 616. P-channel gate 6200 may include drain 622, N-channel 624, and source 626. Based on the received control signal, push pull circuit 600 may open or close gates 610 and 620. Based on the configuration of gates 610 and 620, push pull circuit 600 may transmit a voltage to a hybrid semiconductor device through output 604.

Push pull circuit 600 may support transmitting a voltage to both N-channel and P-channel MOSFETS as well as N-channel and P-channel IGBTs.

FIG. 7 illustrates different patterns, such as those described with respect to FIG. 4, that gate driver 500 may configure for output stages 524. Pattern 710 illustrates a configuration of output stages 524' and 524". The configuration of pattern 710 includes a first time difference 712 and a second time difference 714.

The time differences 712 and 714 may be relative times between two or more output stages 524. Pattern 710 is configured to transmit a voltage via output stage 524" for less time than it transmits a voltage via output stage 524'. For example, output stage 524' may start transmitting a first voltage to a SiC MSOFET at a first time. Output stage 524" may delay transmitting a second voltage to a Si IGBT until after time difference 712 has past relative to the first time. Output stage 524" may terminate transmitting a second voltage to a Si IGBT at a second time. Output stage 524' may terminate transmitting a first voltage to a SiC MOSFET until after time difference 714 has past relative to the second time.

Based on a junction temperature and an inverter output current, the configuration of the output stages may be modified. For example, pattern 710 may be adjusted to pattern 720 or pattern 730.

Pattern 720 is configured to transmit a voltage via output stage 524" for less time than it transmits a voltage via output stage 524'. However, pattern 720 starts transmitting a first voltage and a second voltage at the same time as shown in FIG. 7. For example, output stage 524' may start transmitting a first voltage to a SiC MSOFET and output stage 524" may start transmitting a second voltage to a Si IGBT at a first time. Output stage 524" may terminate transmitting a second voltage to a Si IGBT at a second time. Output stage 524' may delay terminating transmitting a first voltage to a SiC MOSFET until after time difference 724 has past relative to the second time.

Pattern 730 is configured to transmit a voltage via output stage 524" for the same time than it transmits a voltage via output stage 524'. Here first time difference 732 and second time difference 734 are the same amount of time. For example, output stage 524" may start transmitting a second voltage to a Si IGBT at a first time. Output stage 524' may delay transmitting a first voltage to a SiC MOSFET until after time difference 732 has past relative to the first time. Output stage 524" may terminate transmitting a second voltage to a Si IGBT at a second time. Output stage 524' may terminate transmitting a first voltage to a SiC MOSFET until after time difference 734 has past relative to the second time.

A person of skill in the art will understand that the first time difference and the second time difference may be configured to create many different patterns. For example, where both output stages start and stop transmitting voltages at the same time. The configuration output stages 524 are such that a first output stage can switch on earlier or later or at the same time compared with a second output stage. The same holds true for switching off. A first output stage can switch off earlier or later or at the same time compared with a second output stage. Any two out of the plurality of output stages can have the same performance when controlled by second controller 520.

FIG. 8 illustrates a method 800 to control a first current and a second current and control output stages 524. Steps 802 - 808 includes reading the ADC channels 531-534 of ADC 530. For example, each channel 531-534 may correspond to a different register. Step 802 includes receiving an ADC setting from an ADC register. Step 804 includes receiving a loss model setting from a loss register. Step 806 includes receiving a thermal model setting from a thermal register. Step 808 includes receiving a gate driver algorithm setting from a control register. Steps 804 -808 may receive settings form ADC channels 531-532.

Step 810 includes calculations based on the information received from the ADC channels 531-534. Step 810 includes estimating the junction temperature of the hybrid semiconductor device based on the received information and comparing it to a maximum allowable junction temperature.

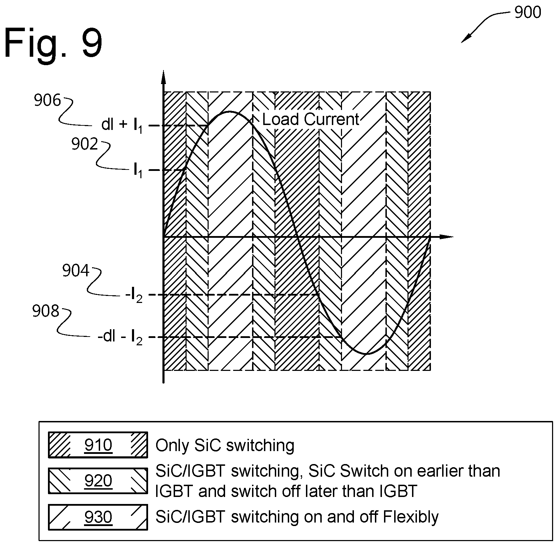

Method 800 may include two layers. A first layer may include elements 812-826 to determine if an allowable junction temperature of a hybrid semiconductor device may be maintained with a current adjustment as described with reference to FIG. 9. A second layer may include elements 840-852 to adjust a first time difference and/or a second time difference based on the operating mode and generate a PWM according to the working mode.

Steps 816 and 822 correspond to a first operation mode 840. First operation mode 840 corresponds to an operation mode when the inverter output current is within the current magnitudes 902 and 904as shown in FIG. 9. Therefore, operation mode 840 may correspond to mode 910 of FIG. 9.

Steps 818 and 824 correspond to a second operation mode 842. Second operation mode 842 corresponds to an operation mode when the inverter output current is within the current magnitudes 906 and 902 or current magnitudes 904 and 908 as shown in FIG. 9. Therefore, operation mode 842 may correspond to mode 920 of FIG. 9.

Steps 820 and 826 correspond to a third operation mode 844. Third operation mode 844 corresponds to an operation mode when the inverter output current is greater than current magnitudes 906 and 908 as shown in FIG. 9. Therefore, operation mode 844 may correspond to mode 930 of FIG. 9.

Method 800 proceeds to steps 814, 816, 818, and 820 determining that the temperature difference of the hybrid semiconductor device is greater than a temperature difference threshold. Method 800 proceeds to steps 822, 824, and 826 after determining that the temperature difference of the hybrid semiconductor device is less than a temperature difference threshold. Method 800 may proceed to either steps 814, 816, 818, and 820 or steps 822, 824, and 826 when the temperature difference is equal to the temperature difference threshold.

Step 812 may compare a hybrid semiconductor temperature difference to a temperature difference threshold, where the hybrid semiconductor temperature difference is a difference between the junction temperature of a Si IGBT and a SiC MOSFET of the hybrid semiconductor.

If the temperature difference is greater than the temperature difference threshold, step 814 determines if can adjust a first current and/or a second current to maintain the temperature difference within an allowable temperature difference. Step 814 will determine a delta current from an adjustment table.

Step 814 will adjust the first current and/or the second current by a value of the delta current of the adjustment table as described with respect to FIG. 9.

Steps 816 and 822 determine if the inverter output current is within the current magnitudes. For example, between current magnitudes 902 and 904 as shown in FIG. 9. If so, the current adjustments are enough to maintain the junction temperature of the hybrid semiconductor device within a valid operating temperature and the operation mode is maintained. An adjustment of the first time difference and/or the second time difference is not necessary. Step 846 generates PWM signal according to first operation mode 840.

If steps 816 and 822 determine that the inverter output current is not within current magnitudes 902 and 904, the multi-layer method may proceed to steps 818 and 824 respectively. Steps 818 and 824 determine if the inverter output current is within the adjusted current magnitudes. For example between magnitudes 906 and 902 or between 904 and 908 as shown in FIG. 9. If so, method 800 determines that operation should proceed according to second operation mode 842 and proceeds to step 848. Step 848 determines if the temperature differences is greater than allowable temperatures difference. If the temperature difference is greater than an allowable temperature difference, the multi-layer method 800 proceeds to step 852. Step 852 adjusts the first time difference and/or the second time difference according to second operation mode 842. After adjusting the first time difference and/or the second time difference at step 852 or determining that temperature difference is below a temperature difference threshold, method 800 proceeds to step 846. Step 846 generates PWM signal according to second operation mode 842.

If steps 818 and 824 determine that the inverter output is not within the adjusted current magnitudes 906 and 902 or 904 and 908, method 800 proceeds to steps 820 and 826. Step 820 and 826 determine if the inverter output current is greater than the adjusted current magnitudes. For example magnitudes 906 and 908 as shown in FIG. 9. If so, method 800 determines that operation should proceed according to third operation mode 844 and proceeds to step 850. Step 850 and step 848 may be combined into one step. Step 850 determines if the temperature differences is greater than allowable temperatures difference. If the temperature difference is greater than an allowable temperature difference, the multi-layer method 800 proceeds to step 852. Step 852 adjusts the first time difference and/or the second time difference according to third operation mode 844. After adjusting the first time difference and/or the second time difference at step 852 or determining that temperature difference is below a temperature difference threshold, method 800 proceeds to step 846. Step 846 generates PWM signal according to third operation mode 844.

If steps 820 and 826 determine the inverter output current is higher than the rated current value, method 800 proceeds to protection mode 828 such as an over current protection mode.

A person of skill in the art will understand that comparing the inverter output current to the current magnitudes as in steps 806, 818, 820, 822, 824, and 826 may include and equality. For example, when determining if the inverter output current is greater than a current magnitude could be stated as greater than or equal to.

FIG. 9 illustrates a chart 900 of the three different modes of exemplary method of FIG. 8 based on the inverter output current. The inverter output current is received from the hybrid semiconductor device and method 800 may control the gate driver based on the inverter output current. First controller 510 may initialize the process based on the received information from the ADC channels 531-534. For example, ADC-REG, Loss-REG, CONTROL-REG and THERMAL-REG. This corresponds to steps 802-808 of method 800. If the temperature difference between the SiC MOSFET and Si IGBT of hybrid semiconductor device is less than a maximum allowable difference, then the junction temperature difference is proper. Therefore, there is no is no need to modulate a first current 902, 904 and a second current 906, 908 or a delta current (dl). The proposed controller will define modes based on the inverter output current relationship with the first current, the second current, and dl. However, if the junction temperature is not within predefine range, the proposed controller enters over current protection.

This corresponds to steps 814-820 of method 800. If the difference between the SiC MOSFET and Si IGBT of hybrid semiconductor device is greater than (or equal to) a maximum allowable difference, than the SiC MOSFET and Si IGBT have big junction temperature difference. There is a need to modulate 11, I2 and dl. The proposed controller will define new I1, I2 and dI to I1N, I2N and dIN based on pre-characterized adjust table in CONTROL-REG Then the proposed controller will define modes based inverter output current relationship with I1N, I2N and dIN.

If inverter output current is still not within predefine range, the proposed controller enters over current protection. This corresponds to steps 822-826 of method 800. The second controller receives information form the first controller and determines a working mode based on the received information.

Areas 910, corresponding to step 840 of FIG. 8, corresponds to a regions where the measured current is between measured current values 902 and 904. Here, there may not be a need for any adjustments which results in gate driver 500 to continue to generate pulse width modulation (PWM) signal.

Areas 920 and 930,corresponding to steps 842 and 844 of FIG. 8, correspond to areas where the measured current is greater measured current absolute values 902 and 904. Here the first controller will determine the relationship between the junction temperature of the hybrid device and the maximum allowable temperature difference. If the junction temperature difference is proper, for example between values 902 and 906 or between values 904 and 908 as shown by area 920,there may be no need to adjust the first time difference or the second time difference because current adjustment may have resolved the issue. If the junction temperature is not proper, for example above values 906 and 908 as shown in area 930, the second controller must adjust the first time difference and/or the second time difference.

Gate driver 500 is not confined to this method. A custom algorithm may be stored on the first controller or the second controller. Using two JTAG interfaces of gate drive 500, the customized algorithm may be uploaded to gate driver 500.

FIG. 10 Fig. 10 shows an application 1000 of gate driver 500 with a hybrid semiconductor device 1030. Application 1000 includes isolated power supply 1002, microcontroller (MCU) 1004, and resistors 1006 connected to gate driver 500. Resistors 1006 are connected to hybrid semiconductor device 1030. Semiconductor module 1030 may have a large volume an include an NTC connected with ADC channels to detect NTC temperature to estimate SiC MOSFET temperature and Si IGBT temperature inside power module 1030. Other ADC channels can be also used as well as other ways of estimating temperatures. The output inverter current, shown on AC in FIG. 10, is connected with ADCch1 and other ADC channels can be also used. Some registers may be gate resistors for SiC MOSFET and others may be gate resistors for Si IGBT. A person of skill in the art will understand that gate resistors 1006 can be configured in many ways. For instance Rg1-Rg2 is used for SiC MOSFET while Rg3-Rg6 are used for Si IGBT. This depends on the ratio of die numbers between SiC MOSFET and Si IGBT inside power module 1030, which are configurable.

FIG. 11 shows an application 1100 of gate driver 500 with discrete Si IGBT devices 1130 connected in parallel with discrete SiC MOSFET devices 1132. Application 1100 includes isolated power supply 1002, MCU 1104, and resistors 1106 connected to gate driver 500. Resistors 1106 are connected to the plurality of discrete Si IGBT devices 1130 and the plurality of discrete SiC MOSFET devices 1132.

The architecture of application 1100 shows three discrete Si IGBT devices 1130 in parallel with three discrete SiC MOSFET devices 1132. A person of skill in the art will understand that other configurations are possible. For example, two SiC MOSFET devices and four Si IGBT device, one SiC MOSFET device and five Si IGBT devices, four SiC MOSFET devices and two Si IGBT devices, or one SiC MOSFET device and three Si IGBT devices. As long the total number of parallel discrete device is less than or equal to the number of output stages.

At least two temperature measurements shall be connected with the ADC channels 1122 and 1124 in which one is for SiC (1122) and the other one is for IGBT (1132). The configuration may be customized based on the application.

Additionally the inverter output current measure is connected to the ADC channels 1126. The discrete devices can be also discrete semiconductor dies inside one power module.

FIGS. 10 and 11 are two examples which utilize gate driver 500. All variables are calculated at the gate driver IC 500 level. Gate drive 500 may be customized in other configuration making gat drive flexible for multiple applications. For example, the inverter current may be obtained through a SPI from MCU 1004 or 1104. MCU 1004 and 1104 may calculate the junction temperatures of Si IGBT devices and junction temperatures of SiC MOSFET devices and transmit the information to gate driver 500 through SPI 512.

This allows gate driver 500 to provide drive inputs for hybrid SiC and IGBT power semiconductor with pre-integrated code template, or customized code based on the application.

A person of skill in the art will understand that gate resistors 1106 can be configured in many ways. For instance Rg1-Rg2 is used for SiC MOSFET while Rg3-Rg6 are used for Si IGBT. This depends on the ratio of die numbers of SiC MOSFET and Si IGBT discrete devices 1130 and 1132.

While the disclosure has been described with reference to exemplary embodiments, it will be understood by those skilled in the art that various changes may be made and equivalents may be substituted for elements thereof without departing from the scope of the disclosure. In addition, many modifications may be made to adapt a particular situation or material to the teachings of the disclosure without departing from the essential scope thereof. Therefore, it is intended that the disclosure not be limited to the particular embodiments disclosed, but that the disclosure will include all embodiments falling within the scope of the appended claims.

## Claims

1. A gate driver integrated chip comprising:
a high voltage side and a low voltage side, wherein the high voltage side is insulated from the low voltage side;
two or more output stages on the high voltage side configured to transmit a first voltage to a silicon carbide metal-oxide-semiconductor field-effect transistor, SiC MOSFET, and transmit a second voltage to a silicon insulated-gate bipolar transistor, Si IGBT;
a first controller on the low voltage side;
a second controller on the high voltage side in communication with the two or more output stages; and
an analogue-to-digital, ADC, circuit on the high voltage side;
wherein the first controller is in communication with both the ADC circuit and the second controller, and
wherein the ADC circuit is in further communication with the second controller,
wherein the ADC circuit is configured to receive an inverter output current, a SiC MOSFET temperature, and a Si IGBT temperature,
wherein the first controller is configured to:
receive the inverter output current, the SiC MOSFET temperature, and the Si IGBT temperature via the ADC circuit;
determine a temperature difference based on the inverter output current, wherein the temperature difference is a difference between the SiC MOSFET temperature and the Si IGBT temperature;
adjust a first current and a second current based on the temperature difference and determine an operation mode,
wherein the second controller is configured to:
receive a mode information of the operation mode from the first controller,
receive a temperature difference from the first controller,
determine a first time difference and a second time difference, wherein the first time difference is a time difference between a time when the first output stage switches on and a time when the second output stage switches on and the second time difference is a time difference between a time when the first output stage switches off and a time when the second output stage switches off based on the temperature difference and the mode information,
control at least one gate of the two or more output stages based on the first time difference and the second time difference.

2. The gate driver of claim 1, wherein the ADC circuit includes four channels.

3. The gate driver of claim 2 further comprising:
a first communication line between the ADC circuit and the first controller;
a second communication line between the ADC circuit and the second controller; and
a serial peripheral interface, SPI, in communication with the second controller to configure the four channels of the ADC circuit, wherein the second controller can transmit register information of the four ADC channels to the first controller.

4. The gate driver of any of the preceding claims wherein the first controller is configured to store a value of the maximum temperature difference.

5. The gate driver of any of the preceding claims wherein the first controller increases or decreases the first current when the temperature difference is less than or equal to the maximum difference.

6. The gate driver of any of the preceding claims wherein the first controller increases or decreases the second current when the temperature difference is less than or equal to the maximum difference.

7. The gate driver of any of the preceding claims wherein the second controller controls the at least one gate to generate a first time difference and a second time difference between a first output stage and a second output stage, wherein the first time difference is a time difference between when the first output stage switches on and the second output stage switches on and the second time difference is a time difference between when the first output stage switches off and the second output stage switches off.

8. The gate driver of any of the preceding claims wherein the first time difference is set to switch on the first output stage and the second output stage at the same time.

9. The gate driver of any of the preceding claims wherein the first time difference is set to switch on the first output stage before the second output stage.

10. The gate driver of any of the preceding claims wherein the first time difference is set to switch on the first output stage after the second output stage.

11. The gate driver of any of the preceding claims wherein the second time difference is set to switch off the first output stage and the second output stage at the same time.

12. The gate driver of any of the preceding claims wherein the second time difference is set to switch off the first output stage before the second output stage.

13. The gate driver of any of the preceding claims wherein the second time difference is set to switch off the first output stage after the second output stage.

14. The gate driver of any of the preceding claims wherein the second controller adjusts the first time difference and/or the second time difference in response to the temperature difference being greater than or equal to the maximum temperature difference.

15. The gate driver of any of the preceding claims wherein the second controller is configured to store an algorithm, wherein the algorithm is set to configure the first time difference and the second time difference.
